Europäisches Patentamt

European Patent Office

Office européen des brevets

(19)

(11) Publication number: **0 247 617**
A2

# EUROPEAN PATENT APPLICATION

(21) Application number: **87107771.5**

(22) Date of filing: **27.05.87**

(51) Int. Cl.⁴: **H 01 L 23/52**, H 01 L 21/48

(30) Priority: **29.05.86 JP 122147/86**

(43) Date of publication of application: **02.12.87**
**Bulletin 87/49**

(84) Designated Contracting States: **DE FR GB**

(71) Applicant: **NARUMI CHINA CORPORATION, 3,**
**Aza-Denjiyama Narumicho Midori-ku, Nagoya-shi Aichi**
**(JP)**

(72) Inventor: **Nishigaki, Susumu, 3-47, Shinonokaze**
**Narumicho Midori-ku, Nagoya-shi Aichi (JP)**
Inventor: **Yano, Shinsuke, 22-1, Ubakoyama Narumicho**
**Midori-ku, Nagoya-shi Aichi (JP)**
Inventor: **Kawabe, Hiroshi Corpo Tokai 101, 2241,**
**Aza-Shinyashiki Ohaza-Hirabari Tenpakucho,**
**Tenpaku-ku Nagoya-shi Aichi (JP)**
Inventor: **Nonomura, Toshio, 54-1, Aza-Bungi Narumicho**
**Midori-ku, Nagoya-shi Aichi (JP)**

(74) Representative: **Dipl.-Ing. Schwabe, Dr. Dr. Sandmair, Dr.**
**Marx, Stuntzstrasse 16, D-8000 München 80 (DE)**

(54) **Multilayer ceramic substrate with circuit patterns.**

(57) A multilayer ceramic substrate with circuit patterns in which Ag conductor patterns having a sheet resistivity lower than 3 milliohms/square are formed inside the substrate by co-firing with green ceramic sheets and Au conductor patterns are formed onto the surface of the substrate in such a way that said Au conductor patterns are electrically connected with said Ag conductor patterns. In such an arrangement, high reliable multilayer substrates can be readily obtained without increasing production cost, while maintaining superior properties of Au. If desired, a metal layer different from the foregoing conductor patterns may be interposed between the Ag conductor pattern and the Au conductor pattern. The metal layer prevents diffusion of Ag to the Au conductor patterns and provides much higher improvements anti-migration property and reliability.

-1-

MULTILAYER CERAMIC SUBSTRATE WITH CIRCUIT PATTERNS

BACKGROUND OF THE INVENTION

[Field of the Invention]

The present invention relates to a multilayer ceramic substrate containing interconnected circuit patterns which is used in an electronic industry, such as in the manufacture of electronic devices or articles for domestic use or computers, etc.

More specifically, the present invention relates to a low-temperature fired multilayer ceramic substrate having Ag internal conductor patterns which are co-fired with ceramic green sheets and external Au conductor patterns electrically connected with the Ag conductor patterns.

[Description of the Prior Art]

Heretofore, circuit substrates using ceramics as an insulator have been used in various electronic devices or equipments.

As typical examples, there have been known co-fired type multilayer ceramic substrates using tungusten (W) or molybdenum (Mo) as conductors for wiring in which the substrates have been co-fired with the W or Mo conductors in a reducing atmosphere in order to prevent oxidation of these conductors.

However, such conventional substrates are disadvantageous due to the use of W or Mo in that the resistivity of the resultant conductor is of the high order of 10 to 20 milliohms/square and Au or Ni plating is needed as an after-treatment to make possible packaging of semiconductor elements, such as LSI chips, or soldering of parts.

In recent years, there have been developed multilayer ceramic substrates having co-fired conductors in which conductive materials of low sheet resistivity, such as Ag, Au or Cu, have been used as the conductors and ceramic materials fireable at temperatures below the melting points (800 to 1100 °C) of the conductive materials are used as an insulator.

When Ag base conductive materials are used as the conductors in the aforesaid co-fired type multilayer ceramic substrates, a metal component, such as Ag, in the conductors formed on the external surface of the multilayer substrate tends to migrate and thereby causes serious problems, such as decrease of insulation resistance or short circuit. As a measure of preventing such a migration of Ag, etc., for example, in Ag-Pd system conductors, palladium content is increased. However, in such a case, the conductor resistivity will be unfavorably increased to the orders of 20 to 30 milliohms/square.

On the other hand, when Cu is used as the conductors in the multilayer ceramic substrate, firing is carried out at a relatively low temperature of the order of 800 to 1100 °C and a neutral atmosphere or a

-3--

reducing atmosphere is employed in order to prevent oxidation of copper. In such firing conditions, an organic binder employed to make ceramic insulator material powder castable can not be fully burned off and residues of the resin binder component remain as carbon, thereby causing a serious decrease of insulation resistance. Therefore, a very prolonged binder removal procedure is necessary and this is undesirable for practical use. The Cu conductors are advantageous to the Ag conductors in anti-migration properties, but they may also occur similar migration problems in certain cases.

Alternatively, when Au is used as the conductors in the multilayer substrate, such conductors can almost entirely free from the foregoing migration problems and achieve a highest level of reliability. Further, in many cases, Au has been used in electrodes for mounting semiconductor elements, such as LSI chip, and in elctrodes to be bonded to wires which are connected to LSI chips. Recently, in multilayer substrates used in high-speed electronic devices, such as super computers, attempts have been made to increase the density of signal lines by laminating techniques. In achieving high speed in the signal lines, the resistivity of conductors play a dominant role. In view of the fact that Ag has a low conductor resistivity less than 3 milliohms/square in comparison with the conductor resistivity of Au, i.e., 3 to 4 milliohms/square, it would be advantageous if all conductors could be formed from Ag to minimize the circuit resistivity of multilayered signal lines. In the conventional super computers or the similar high-speed electronic devices in which multilayer substrates with Au conductors have been used, much higher speed is increasingly required and it is strongly desired to minimize conductor resistivity.

## SUMARRY OF THE INVENTION

An object of the present invention is to provide a multilayer ceramic substrate with circuit patterns with a view to eliminating the foregoing problems experienced in the prior art.

Another object of the present invention is to provide a multilayer ceramic substrate having circuit patterns in which circuit resistivity is minimized and migration problems are eliminated.

In accordance with the present invention, there is provided a multilayer ceramic substrate with circuit patterns in which Ag conductor patterns having a sheet resistivity less than 3 milliohrms/square are formed inside the substrate by co-firing with green ceramic sheets and Au conductor patterns are formed onto the surface of the substrate in such a manner that the Au conductor patterns are electrically connected with the Ag conductor patterns.

In such an arrangement of the present invention, inexpensive Ag conductor materials having a low sheet resistivity less than 3 milliohms/square are used at portions where migration is not likely to occur in the multilayer substrate and at portions where it is needless to consider so seriously about migration on the surface. On the other hand, Au is used only at particular portions, namely, in electrodes for mounting semiconductor elements, such as LSI chips, and for bonding wires which are connected to LSI chips and at portions where a good anti-migration and a high reliability are particularly required in patterns and, thereby, the use of expensive Au is restricted.

As the Ag conductor, Ag or Ag base conductive materials containing at least one selected from the group consisting of Pd, Pt and Rh may be used. The addition of Pd, Pt and/or Rh should be limited to the range of 2% or less so as not to substantially affect the conductor resistivity of the Ag conductor. These additive metals have effects in preventing camber of the conductor patterns and diffusion of the conductive materials occurring during co-firing with the green ceramic sheets. Since the Ag conductors are formed by co-firing with the green ceramic sheets, the resultant internal Ag conductors have a very high reliability. Further, the conductor resistivity and production cost can be greatly reduced in comparison with the case where conductors are formed mainly from an expensive Au conductive material. In addition to such advantages, the substrate also has advantageous conductor properties and high reliability of Au at certain portions where Au conductive material is needed.

In one preferred aspect of the present invention, a different metal layer is interposed between the Ag conductor and the Au conductor. The metal layer is made of a metal which neither causes diffusion into the Ag conductor nor undergoes diffusion of the Ag conductors at the firing temperature of the Au conductor and examples of such a metal are Ni, Cr, Ti and Pd. The metal layer can be formed by plating, vapor deposition, sputtering or thick-film firing process. The metal layer is provided in order to prevent diffusion of the Ag conductor into the Au conductors during firing the Au conductors and thereby prevent deterioration of the anti-migration property and reliability of the Au conductors.

The present invention will be now explained below in detail by referring to the accompanying drawings. Throughout this specification and claims, the term "Ag conductor" or "Ag conductor pattern" is used to mean a conductor or conductor pattern composed of Ag or Ag with other conductive materials in small amounts, unless otherwise specified. Similarly, "Au conductor" or "Au conductor pattern" may also contain, in addition to Au, other conductive materials.

## BRIEF DESCRIPTION OF THE DRAWINGS

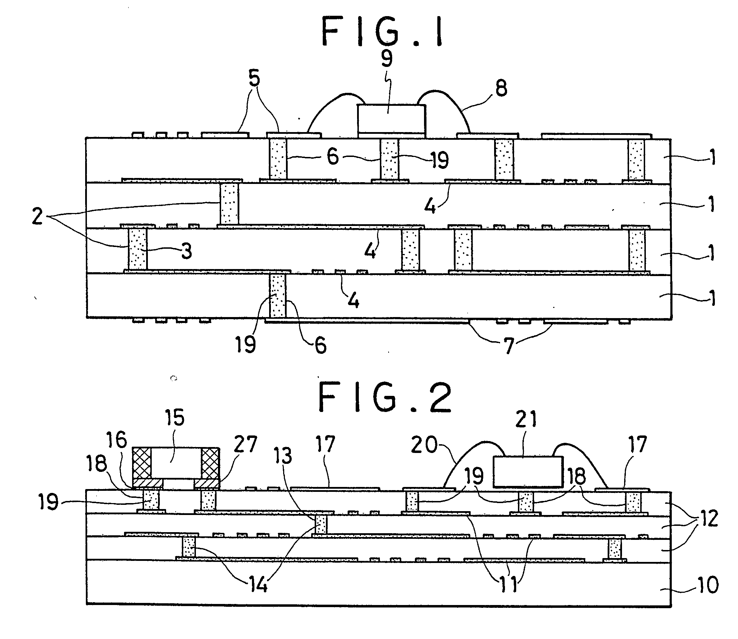

FIG. 1, FIG. 2 and FIG. 3 are schematic views illustrating preferred embodiments according to the present invention.

## DETAILED DESCRIPTION OF THE PREFERRED EMBODIMENTS

Ceramic insulator materials which are fireable at temperatures lower than the melting point of the Ag conductive material to be layered inside the multilayer substrate can be used for the substrate of the present invention. For instance, when Ag or Ag base alloy containing Pd, Pt and/or Rh in a small content is used in the Ag conductors, it is requested that the ceramic insulator material be fireable at temperatures ranging from 800 to 1100 °C, since these multilayered conductive metals have relative low melting points of about 900 to 1200 °C. Typical examples of such low-temperature fireable ceramic insulator materials include the following materials.

(1) Mixture of glass powder and ceramic powder, the glass powder being borosilicate glass powder or borosilicate glass powder containing several kinds of oxide components (e.g., oxides of alkali metal or alkaline earth metal; or PbO, ZnO, $Al_2O_3$ MnO, $Cr_2O_3$, etc.) and the ceramic powder being alumina, quartz, chromium oxide, mullite, cordierite, etc.

In the firing process of the mixture, the glass powder may be crystallized or create crystallized products due to the reaction with the ceramic powder.

(2) Crystallizable glass powder which provides crystallites of cordierite, alpha-spodumene, celsian, anorthite, wollastonite, etc., during the firing process.

(3) Glass-free insulator material composed of alkali metal oxide, alkaline earth metal oxide, $SiO_2$ and other oxide additives, such as $B_2O_3$, $Al_2O_3$, $Cr_2O_3$, ZnO, $ZrO_2$. In the provision of such a material, as starting materials for the foregoing oxides, thermally decomposable compounds (e.g, $CaCO_3$ for CaO) may be used and, in this case, these compounds are mixed and calcined to form the foregoing material.

The substrate of the present invention is preferably formed in a laminated multilayer form by utilizing a sheet laminating process or a sheet printing process.

When the green sheet laminating process is employed, green sheets with a thickness of the order of 0.1 to 0.5 mm are prepared from the foregoing ceramic insulator material by a conventional doctor blading technique and conductor patterns are printed onto the individual green ceramic sheets, using Ag base conductive paste. A desired number of the green ceramic sheets are laminated together and then hot-pressed at a temperature of 80 to 150 °C and at a pressure of 50 to 250 $kg/cm^2$ to form a monolithic body.

Electrical interconnection with the conductor layers is achieved by the Ag conductor in through holes, 0.2 to 0.5 mm in diameter, formed in the green sheets.

When the multilayer substrate is fabricated by the sheet printing process, a base green ceramic sheet, approximately 0.3 to 2.0 mm in thickness, is prepared in the same way as in the sheet laminating process previously described. Onto this green sheet, a ceramic insulator paste having the same composition as that of the green sheet and the foregoing Ag base conductive paste are alternately printed to form multilayered conductor patterns. Interconnection between the conductor layers is achieved through via holes having a diameter of the order of 0.2 to 0.5 mm.

When it is desired to form resistors by co-firing with the substrate, a resistive paste and a conductive paste for electrodes for the resistors are printed onto and, if necessary, inside the substrate.

The multilayer body obtained by the sheet laminating process or the sheet printing process as set forth above are usually fired at temperatures of 800 to 1100 °C in an oxidizing atmosphere.

The Au conductors are formed by printing a Au base conductive paste in a desired conductor pattern onto the foregoing multilayer ceramic substrate with the circuit patterns and then firing. The firing temperature is in the range of 800 to 1000 °C. If desired, the Au conductive paste may be printed onto the un-fired green multilayered substrate and co-fired with the Ag conductors at 800 to 1100 °C. During the firing process, the intelayered Ag conductors may diffuse into the Au conductors depending on the firing temperature and the composition of the Au conductors employed and form an opening between the Au conductors and the Ag conductors, thereby breaking electrical connection between them. For example, such a break is caused at the junction part between the Ag conductor in the through holes formed the top surface layer and the Au conductor formed onto this surface layer. In such a case, a Ag base conductive material containing one or more metals of Pd, Pt and Rh in amounts of 2% or less and having a sheet resistivity lower than 3 milliohms/square is used for the formation of the Ag conductors.

In the formation of the Au conductors on the fired multilayer substrate, Ag conductors and/or resistors of $RuO_2$ type or $RuO_2Bi_2O_7$ type may be formed by co-firing with the Au conductors or by separately firing. Further, after the firing operation of the conductors and/or the resistors, Cu conductors may be formed by firing in a neutral or reducing atmosphere.

In some cases, the conductive components of the Au conductors and Ag conductors may diffuse into each other at the junctions of these conductors during firing the Au conductors and the Ag component diffusing into the Au conductors will impair the anti-migration properties of the Au conductors, thereby lowering the reliability. Therefore, when a high level of reliability is required, a different metal layer, as set forth above, is interposed between these two types of conductors in order to prevent the diffusion of the Ag component.

The present invention will now be described in detail with reference to the following Examples. Percentages specified in the Examples are all by weight, unless otherwise indicated.

Example 1

A ceramic insulator mixed powder consisting of 60% of glass powder consisting of 18.2% of CaO, 18.2% $Al_2O_3$, 54.5% of $SiO_2$ and 9.1% of $B_2O_3$ which was prepared by melting a glass-forming material at 1450 °C, quenching in water and grinding to an average particle size of 3 to 3.5 $\mu m$; and 40% of alumina powder having an average particle size of 1.2 $\mu m$ was prepared and, then, solvent (e.g. toluene, xylene or alcohols), binder (acrylic resin) and plasticizer (dioctyl phthalate) were added to the mixture. The resulting mixture was fully blended to obtain a slurry having a viscosity of 2000 to 40000 cps and was cast into a green sheet, 0.4 mm in thickness, by conventional doctor blading techniques.

FIG. 1 illustrates collectively all the fabrication steps as an expedient measure. As shown in FIG. 1, the green sheet 1 obtained above was cut into dimensions of 30 mm x 30 mm and through holes 2 with a diameter of 0.3 mm were formed. The through holes 2 were filled with a Ag conductive paste 3, which was prepared by adding binder (ethyl cellulose) and solvent (terpineol) to Ag powder and, then, thoroughly mixing, and an internal Ag conductor pattern 4 was printed using the same Ag conductive paste. Similarly, Ag conductor patterns 4 are printed onto other green sheets 1, except a topmost green sheets 1. A Ag-Pd conductive paste 19 was prepared by adding binder (ethyl cellulose) and solvent (terpineol) to a powder mixture of 85% of Ag and 15% of Pd and fully mixing together and was extruded into through holes 6 with a diameter of 0.3 mm. The green sheets 1 were laminated together in such a manner that the top end of the extruded Ag-Pd conductive paste 19 is exposed at the surface of the multilayered body and hot pressed at 100 °C and 100 kg/cm$^2$ to obtain a monolithic green ceramic body.

The obtained body was fired at a temperature of 900 °C for 20 minutes in an oxidizing atmosphere in an electric continuous belt furnace usually used. The fired Ag electrodes possessed a low sheet resistivity of 2.4 milliohms/square.

A Au conductor pattern 5 was printed onto the top surface of the multilayer substrate thus obtained, using Au base conductive paste 5715 commercially available from E.I. Du Pont Nemours Co. and electrically connected with the Ag internal conductors 4 through the through holes 6. After printing the Au conductor pattern 5, the pattern was fired at 850 °C over a period of ten minutes in an oxidizing atmosphere in an electric continuous belt furnace usually used. Thereafter, a further Au conductor pattern 7 was printed onto the opposite surface of the substrate and fired.

The Au conductor had a low sheet resistivity of the order of 3.5 milliohms/square.

Au wires 8 with 30 µm in diameter was thermocompression bonded at their both ends to the Au electrode and a LSI chip 9 by a thermosonic bonding technique at 250 °C. When the Au wires 8 were pulled using pincettes, they all snapped and detachment from the bonded portions was not detected. It has been found that the Au wires 8 were all bonded with a sufficient strength to the Au electrode and the LSI chip 9. Further, when the LSI chip 9 was bonded to the Au electrode at 465 °C with a Au-Si eutectic compound, a satisfactory bonding layer was formed between the LSI chip and the Au electrode and no problem arose in bonding strength.

Example 2

A ceramic insulator mixed powder consisting of 60% of glass consisting of 27.3% of CaO, 4.5% $Al_2O_3$, 59.1% of $SiO_2$ and 9.1% of $B_2O_3$ which was prepared by melting the glass-forming material at 1450 °C, quenching in water and pulverizing to an average particle size of 3 to 3.5 μm; and 40% of alumina powder having an average particle size of 1.2 μm was prepared and, using the mixture, a 1.0 mm thick green sheet was made in the same manner as set forth in Example 1. As shown in FIG. 2, the green sheet 10 was cut into dimensions of 30 mm x 30 mm and a Ag-Pd conductor pattern 11 was printed onto the surface of the green sheet 10, using a conductive paste which was prepared by adding binder (ethyl cellulose) and solvent (terpineol) to a powder mixture of 99.5% of Ag and 0.5% of Pd and fully mixing together.

Thereafter, an insulator paste was prepared by adding binder (ethyl cellulose) and solvent (terpineol) to the insulator mixed powder specified above and, then, fully mixing and was printed onto the green ceramic sheet 10 with the printed conductor pattern 11 to form an insulator layer 12 and, then, the Ag-Pd pattern 11 was printed onto the insulator layer 12, as set forth above. The printing procedure was repeated to form a multilayer body as shown in FIG. 2.

An electrical interconnection between the interlayered conductor layers was achieved by filling via holes 13 formed in the insulator layers 12 with the Ag-Pd conductive paste 14.

The multilayered structure obtained in the foregoing procedure was fired at 900 °C for 20 minutes in an oxidizing atmosphere in an electric belt furnace customarily used. The fired Ag-Pd conductor had a sheet resistivity of 2.5 milliohms/square.

In order to mount a passive element 15 onto the substrate thus obtained by solder 27, electrodes 16 were printed by using Au-Pd-Pt conductive paste 4596 manufactured by E. I. Du Pont Nemourse Co., and a Au pattern 17 was printed using Au conductive paste ALP 3133 manufactured by Sumitomo Metal Mining Co. Ltd. The Au conductor pattern 17 was electrically connected to the Ag-Pd internal conductor pattern 11 by filling via holes 18 with the Ag-Pd conductive paste 19 used in the through holes 6 in Example 1. Thereafter, the substrate was fired at 850 °C for 10 minutes in an oxidizing atmosphere in an electric belt furnace usually used. The resultant Au conductors had a low sheet resistivity of 3 milliohms/square.

Au wires 20 with 30 μm in diameter was thermocompression bonded at their both ends to the Au electrode and a LSI chip 21 by a ultrasonic bonding technique at 250 °C. When the Au wires 20 were pulled using pincettes, they all snapped and detachment from the bonded portions was not detected. It has been found that the Au wires 20 were all bonded with a sufficient strength to the Au electrode and the LSI chip 21. Further, when the LSI chip 21, the back of which was plated with Au, was bonded to the Au electrode at 465 °C, a satisfactory bonding layer was formed between the LSI chip 21 and the Au electrode and no problem arose in bonding strength.

Example 3

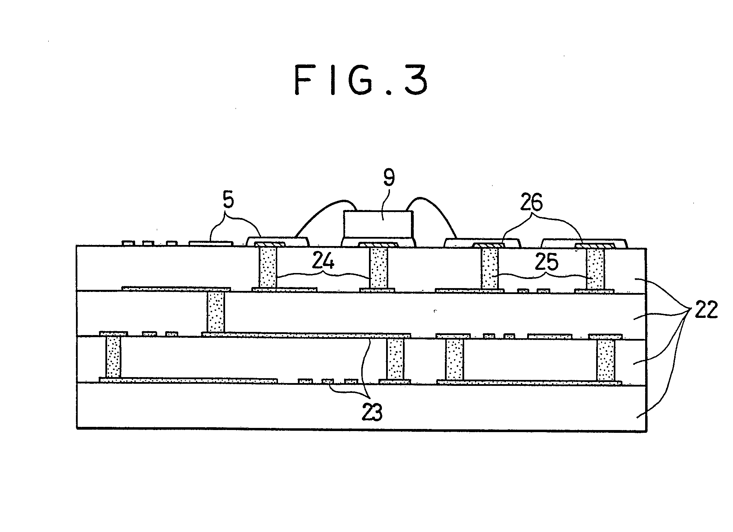

50% of glass powder obtained by pulverizing a commercially available alumino-lead borosilicate glass ($PbO-Al_2O_3-SiO_2-B_2O_3$ system) to an average particle size of 3 to 3.5 μm was mixed with 50 % of alumina powder having an average particle size of 1.2 μm to formulate a powdered ceramic insulator mixture and 0.4 mm thick green sheets 22 (shown in FIG. 3) were prepared in the same way as described in Example 1, using the insulator ceramic mixture. Binder (ethyl cellulose) and solvent(terpineol) were added to Ag-Pt alloy powder consisting of 99% of Ag and 1% of Pt and thoroughly mixed to formulate a Ag-Pt conductive paste.

As shown in FIG. 3, a multilayer body having Ag-Pt conductor patterns 23 was obtained in the same manner as described in Example 1 and then fired at 900 °C for 20 minutes in a coventional electric continuous belt furnace in an oxidizing atmosphere. The fired Ag-Pt conductor had a sheet resistivity of 2.2 milliohms/square.

After firing the substrate in an oxidizing atmosphere, a 3 μm thick nickel metal coating 26 was electrolessly deposited onto an exposed surface portion of the Ag-Pt conductor 25 filled in through holes 24.

After the Ni electroless plating operations, a 3 μm thick Au coating was deposited onto the surface of the Ni coating 26 by electroless plating. Thereafter, a Au conductor pattern 5 was printed, using the Au conductive paste 5715 commercially available from E.I. Du Pont Nemours Co. and then fired in an oxidizing atmosphere at 850 °C for a period of ten minutes, using an electric continuous belt furnace ordinary used.

In such an arrangement, the Ni metal coating prevented the Ag component of the Ag-Pt conductor from diffusing into the Au conductor and no deterioration was found in the properties of the Au conductor. Also, with respect to the mounting of the LSI chip 9 and wire-bondability, good results were obtained as in Example 1.

Example 4

A multilayer ceramic substrate having Ag internal conductors was prepared in the same way as set forth in Example 1, using a ceramic insulator powder mixture which was made up of 50% of glass powder consisting of 80% of $SiO_2$, 12% of $B_2O_3$ and the remainder being alkali metal oxide, alkaline earth metal oxide, etc., and having an average particle size of 2 μm ; 30% of alumina powder having an average particle size of 5 μm; and 20% of chromium oxide having an average size of 4 μm. The multilayer substrate was fired at 950 °C for one hour in an oxidizing atmosphere in an electric continuous belt furnace ordinarily used. Then, a Au conductor pattern was formed onto the surface of the fired substrate in the same was as described in Example 1. The fired internal Ag conductor had a low sheet resistivity of 2.5 milliohms/square and the Au conductor had a sheet resistivity of 3.7 milliohms/square.

Example 5

Green ceramic sheets with a thickness of 0.3 mm were prepared from glass powder of $MgO-SiO_2-Al_2O_3-B_2O_3-ZrO_2-TiO_2$ having an average particle size of 2 μm, in the same way as described in Example 1 and then the Ag-Pd conductive paste used in Example 2 was applied onto the individual green ceramic sheets in the same manner as in Example 1. The thus obtained green ceramic sheets were stacked and hot pressed to yield a laminated monolithic body in the same way as in Example 1. A conductor of 95% Ag -5% Pd was extruded in thorough holes, which were exposed at one end. The multilayered body was fired at 950 °C for 2 hours in an oxidizing atmosphere. The fired Ag-Pd conductors had a sheet resistivity of 2.5 milliohms/square and the fired ceramic was found to be a crystallized glass having a crystallized phase of cordierite.

Using the Au conductive paste 5715 commercially available from E.I. Du Pont Nemours Co., a Au external conductor pattern was formed onto the surface of the substrate obtained above in the same manner as in Example 1. The Au external conductor had a sheet resistivity of 3.6 milliohms/square.

As described above, according to the present invention, high reliable multilayer substrates having internal Ag conductor patterns of low resistivity can be obtained without increasing production cost, while maintaining superior properties of Au, and the anti-migration properties of the conductors are greatly improved.

WHAT IS CLAIMED IS:

1.  A multilayer ceramic substrate with circuit patterns in which Ag conductor patterns having a sheet resistivity lower than 3 milliohms/square are formed inside said substrate by co-firing with green ceramic sheets and Au conductor patterns are formed onto the surface of said substrate in such a way that said Au conductor patterns are electrically connected with said Ag conductor patterns.

2.  A multilayer ceramic substrate as claimed in Claim 1 in which said Ag conductor patterns contain at least one selected from the group consisting of Pd, Pt and Rh in amounts of 2% or less, in additon to Ag.

3.  A multilayer ceramic substrate as claimed in Claim 1 in which said Ag conductor patterns and said Au conductor patterns are electrically connected through a different metal layer interposed between said two kinds of conductor patterns.

4.  A multilayer ceramic substrate as claimed in Claim 3 in which said different metal layer is formed from Ni, Cr, Ti or Pd.

FIG. 1

FIG. 2

# FIG.3